# EUROPEAN PATENT APPLICATION

(11) **EP 3 482 943 A1**
(43) Date of publication of application: **15.05.2019**
(21) Application number: 18020494.3
(22) Date of filing: 11.10.2018
(51) Int. Cl.: B41F 35/00, B41F 15/08, H05K 3/12, B08B 3/02, B08B 1/00, B05B 13/04

(54) **SCREEN CLEANING SYSTEM AND METHOD**

(30) Priority: 12.11.2017 GB 201718673
(71) Applicant: ASM Assembly Systems Singapore Pte. Ltd., Singapore 768924 (SG)
(72) Inventor: Churchill, Simon, Weymouth, Dorset DT4 9TH (GB); Cox, Gerard Anthony, Weymouth, Dorset DT4 9TH (GB); Wright, Grant, Merriott, Somerset TA16 5QG (GB)
(74) Representative: Emerson, Peter James

(57) **Abstract**

A screen-cleaning system for a printing machine which can automatically confirm priming (9) of the cleaning liquid (2), with a programmable cleaning liquid dispensing system which can integrate with this cleaning system and effect efficient cleaning liquid delivery.

## Description

This invention relates to a cleaning system for cleaning a stencil within a printing machine, a cleaning liquid dispensing system, printing machines comprising such systems, and a method of cleaning a stencil.

### Background and Prior Art

Industrial screen-printing machines typically apply print media, such as solder paste or conductive ink, onto a planar workpiece, such as a wafer or circuit board, by applying a medium (e.g. solder paste) through a pattern of apertures in a stencil (sometimes referred to as a foil or a screen) using an angled blade or squeegee. The stencils used are however prone to collecting the print medium on the underside and in the printing apertures. This can reduce performance and even lead to breaking of the workpiece.

To address this problem, an under-screen cleaner is used to clean the lower surface of the stencil. This uses a roll of cleaning material, such as paper or fabric, having a width which is sufficient to at least extend across the pattern of apertures formed within the stencil. The fabric is fed from a supply roll, at least partially wrapped around a plenum and collected on a second roll. At the plenum, the fabric is wetted with cleaning liquid, typically a cleaning solvent, and brought into contact with the underside of the stencil. The correct provision of cleaning solvent to wet the cleaning material is of crucial importance to the efficacy of the cleaning process.

WO2011/144887A1 describes an exemplary under-screen cleaner effective for cleaning stencils. In that cleaner, a pump is used to convey solvent to a dispensing manifold, which has a plurality of fluid delivery outlets which dispense solvent onto the fabric evenly across its width. Alternative systems, including gravity-fed systems, have also been used.

Currently, a solvent dispensing system is used to supply the solvent from a storage tank to the manifold, and hence to the cleaning material. Typically, a monitor is provided on the tank which provides an alert if the tank becomes empty of solvent. However, the priming of such a system is performed manually, which requires a human operator to access the internals of the printing machine to visually check priming. In practice, the operator will need to be able to see the plenum. This in turn requires a protective control system including interlocks, such as requiring the operator to simultaneously press two interlock buttons to stop and open the printing machine, to ensure safe access.

It will be apparent to those skilled in the art that there are various drawbacks to such an approach:
- The printing machine must be stopped, causing a loss of throughput and disruption to the production line;
- The front cover must be opened;
- The cleaning module must be accessed;
- An interlock system is required, which may be expensive and require additional user intervention;
- The stencil may obscure visibility or need to be moved or removed;
- There is a risk of spilt solvents / overflow;
- Correct priming is not guaranteed;
- It is difficult to assure the cleaning fabric roll is suitably coated with cleaning solvents - for example if one or more manifold outlets becomes blocked;
- Solvent may be applied in an uneconomical manner;
- It is necessary to close the front cover and resume printing;
- A manual process is required;
- The printing machine, stencil and / or workpiece may need additional periodic cleaning, or in the worst case the workpiece may be scrapped due to excess contamination; and
- The method is at risk of human error.

The present invention seeks to address all of these problems, and in particular provide a system in which no operator intervention is required, while guaranteeing proper, reliable and efficient solvent provision to the cleaning material.

In accordance with the present invention this aim is achieved by providing a cleaning system which can automatically confirm priming of the cleaning liquid, and further with a cleaning liquid dispensing system which can integrate with this cleaning system and effect efficient cleaning liquid delivery.

### Summary of the Invention

In accordance with a first aspect of the present invention there is provided a cleaning system for cleaning a stencil within a printing machine, comprising:
a control processor,
a tank for storing cleaning liquid,
a cleaning liquid dispensing system comprising a nozzle for dispensing liquid onto a cleaning material,
a feed tube connected between the tank and the nozzle, and
a priming sensor for detecting cleaning liquid within a section of the feed tube, the priming sensor being operative to send a signal to the control system indicative of the detection of cleaning liquid.

In accordance with a second aspect of the present invention there is provided a cleaning liquid dispensing system for dispensing cleaning liquid to a cleaning material within a printing machine, the cleaning material being an elongate sheet structure having a width, comprising:
a guide which spans the width of the cleaning material,
a movable nozzle in fluid connection with a source of cleaning liquid to receive a supply of cleaning liquid therefrom and to dispense the received cleaning liquid, the movable nozzle being movable along the guide to dispense cleaning liquid to a portion of the cleaning material proximate the movable nozzle in use,
an actuator for driving the movable nozzle along the guide,
a control system comprising a control processor for controlling the actuator, the control processor being operative to drive the actuator to move the movable nozzle along the guide along a range of travel while cleaning liquid is dispensed therefrom,
wherein the range of travel is programmable into the control processor.

In accordance with a third aspect of the present invention there is provided a printing machine comprising the cleaning system of the first aspect.

In accordance with a fourth aspect of the present invention there is provided a printing machine comprising the cleaning liquid dispensing system of the second aspect.

In accordance with a fifth aspect of the present invention there is provided a method of cleaning a stencil within a printing machine, comprising the steps of:
i) providing a cleaning system comprising a control processor, a tank for storing cleaning liquid, a cleaning liquid dispensing system comprising a nozzle, and a feed tube connected between the tank and the nozzle; and
ii) detecting cleaning liquid within the feed tube.

Other specific aspects and features of the present invention are set out in the accompanying claims.

### Brief Description of the Drawings

The invention will now be described with reference to the accompanying drawings (not to scale), in which:
FIG. 1 shows a highly schematic plan of key components of the cleaning system in accordance with an embodiment of the present invention;
FIG. 2 schematically shows an end view of the dispensing system of this embodiment; and
FIG. 3 schematically shows a part-top view of a cleaning and dispensing system in accordance with this embodiment.

### Detailed Description of the Preferred Embodiments of the Invention

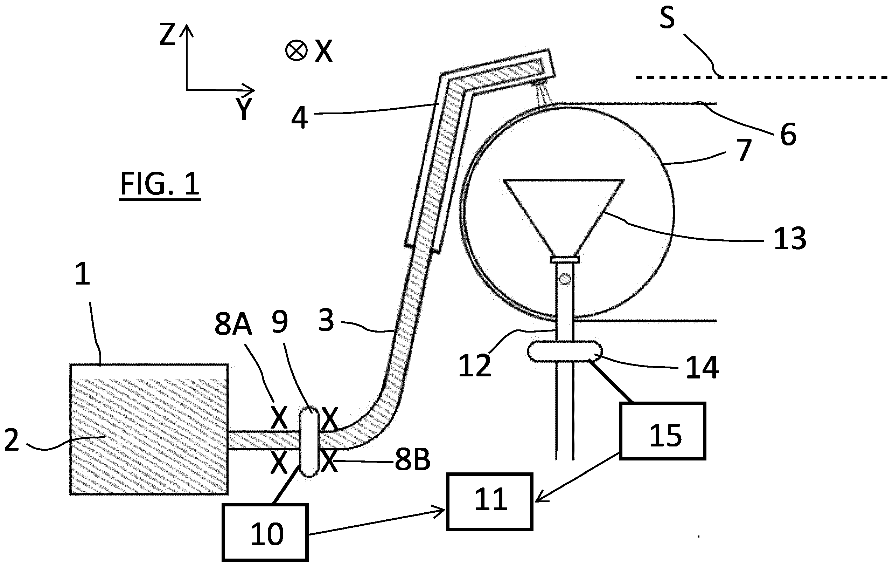

An embodiment of the present invention is schematically shown in section in FIG. 1. This figure is simplified so as to show only certain important features for the understanding of the present invention, and in particular does not show other components of the printing machine in which this apparatus would be housed in use. For ease of understanding, in this embodiment the stencil to be cleaned would lie parallel to the X-Y plane shown in FIG 1, which would be horizontal. The Z-axis extends vertically.

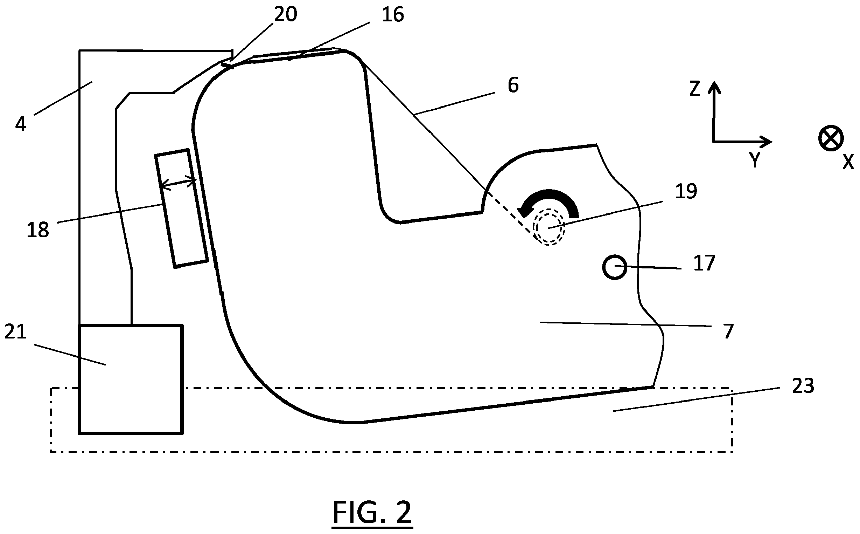

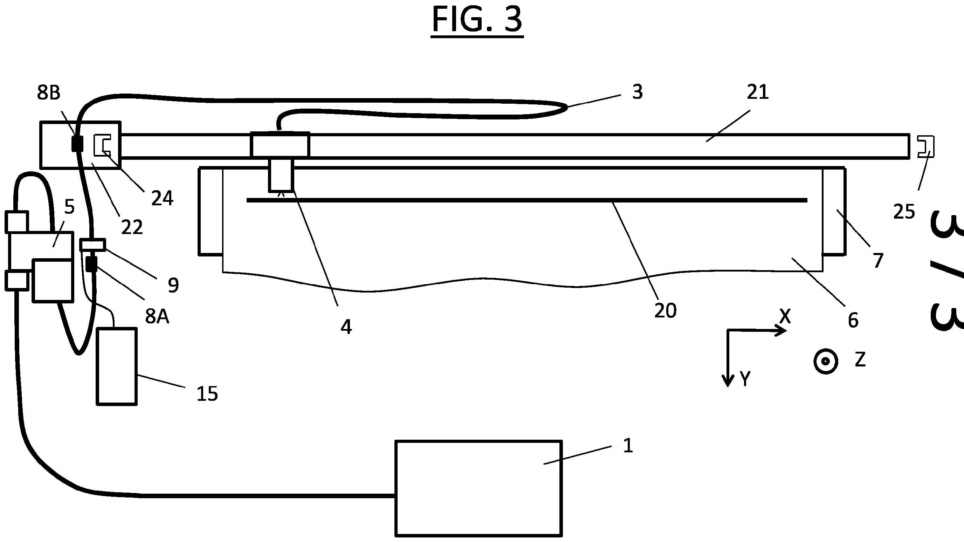

A storage tank 1 acts as a reservoir for a cleaning liquid 2, such as a cleaning solvent. A feed tube 3 is provided to guide cleaning liquid 2 from the storage tank 1 to a nozzle 4. A pump (5, see FIG. 3) acts to transport the cleaning liquid 2 along the feed tube 3 to the nozzle 4, for simplicity this pump is omitted from FIG. 1. The nozzle 4 has an outlet which is arranged to dispense cleaning liquid 2, in the form of a spray, onto the surface of a roll of cleaning material 6, the axis of the roll extending parallel to the X-axis. It should be noted that only a single nozzle 4 is in fluid communication with the storage tank 1, and the nozzle 4 is positioned to be close to the surface of the cleaning material 6 in use, so that the nozzle 4 is effective to wet only a portion of the cleaning material 6 proximate the nozzle 4 at anytime. The cleaning material 6 is wrapped around a movable plenum 7, which can be raised or lowered into and out of contact with an overlying stencil S. In FIG. 1, the plenum 7 is shown in a simplified form, with a circular section. A more detailed representation of the plenum 7 is shown in and described with reference to FIG. 2 below. As will be described in more detail below, the nozzle 4 is movable in a direction parallel to the X-axis, so that as much of the cleaning material as required can be wetted. To allow this movement, the feed tube 3 is flexible, for example being constructed from a flexible plastics material. A section of feed tube 3 is clamped into a static position by means of a pair of clamps 8A, 8B. A priming sensor 9 is provided at this section, for detecting cleaning liquid 2 within the section. In this embodiment, the priming sensor 9 comprises a self-calibrating infra-red (IR) sensor which surrounds the feed tube 3. This type of sensor, which is known from medical applications, enables highly accurate detection of liquid within the tube proximate the sensor. The priming sensor 9 is connected to a priming sensor PCB 10, which interprets output readings from the priming sensor 9 and communicates with a control processor 11, which may be integrated in a computer or other data processing system. The operation of the priming sensor 9 will be described in more detail below. As noted above, the nozzle 4 is movable is a direction parallel to the X-axis. At a "home" position, at one end of the nozzle 4's possible range of travel and beyond the extent of the roll of cleaning material 6, an outlet tube 12 is provided for collecting cleaning liquid 2 from the nozzle 4. The outlet tube 12 is provided with a funnel 13 to assist in the collection of this cleaning liquid 2. The distal end of outlet tube 12 may return the collected cleaning liquid 2 back to the storage tank 1, or alternatively to a disposal tank (not shown) or drain (not shown). An outlet sensor 14 is provided at the outlet tube 12, for detecting cleaning liquid 2 within the outlet tube 12 proximate to the presence sensor 14. In this embodiment, the outlet sensor 14 is constructed similarly to the priming sensor 9, so that it comprises an infra-red (IR) sensor which surrounds the outlet tube 12. The outlet sensor 14 is connected to a presence sensor PCB 15, which interprets output readings from the outlet sensor 14 and communicates with the control processor 11.

The priming sensor 9 and outlet sensor 14 enable the automatic monitoring of very low volumes of liquid or droplets of liquid within the respective tubes 3, 12 which provides an indication of a loss of liquid or droplet detection. Preferably they are self-calibrating, and able to determine the contents of the respective tube at each start-up of the cleaning system, allowing them to match the contents without additional configuration requirements. Both the priming sensor 9 and the outlet sensor 14 remain on and active while the printing machine is turned on.

The priming sensor 9 is arranged to detect the absence of cleaning liquid 2 within the feed tube 3 and indicate the status to the control processor 11 to enable a priming cycle to be completed. This ensures that cleaning liquid 2 will always be available to the nozzle 4 before wetting.

The outlet sensor 14 is operative to detect a change in the presence of liquid within the region of the outlet tube 12 proximate the outlet sensor. In this way, the outlet sensor 14 can detect very small droplets of liquid passing by it, and indicate the occurrence to the control processor 11. This can be used as a confirmation that the nozzle 4 has expelled a quantity of cleaning liquid 2 into the outlet tube 12.

FIG. 2 schematically shows an end view of the dispensing system. Reference numerals are retained as far as possible. Here it can be seen that plenum 7 is shaped so as to provide a flat surface which acts as a cleaning head 16. The plenum 7 is mounted for rotation about a rotation axis 17, to effect rotation about an axis parallel to the X-axis. When the plenum 7 is rotated in a clockwise direction as shown, the cleaning head 16 is raised up so as to be in planar contact with an overlying stencil (not shown). As is generally known in the art, the cleaning head 16 may be supplied with a vacuum port (not shown) to ensure a good contact between the stencil and the area of cleaning material 6 overlying the cleaning head 16. The cleaning material 6 is wrapped around the plenum 7 and selectively clamped to the plenum 7 by a movable clamp 18. The cleaning material 6 is progressively fed around the plenum in a clockwise direction during use so that the cleaning material 6 overlying cleaning head 16 is replaced by fresh cleaning material. The used cleaning material 6 is collected onto a cleaning material roll 19, mounted for rotation in the anticlockwise direction by a material drive (not shown). Tensioning of the cleaning material 6 for cleaning of the stencil is provided by clamping the cleaning material 6 to the plenum 7 with clamp 18 while driving the material drive.

It can be seen that the nozzle 4 overlies plenum 7 closely, to accurately apply a bead 20 of cleaning liquid 2 to the underlying cleaning material 6. Indeed, the nozzle 4 overlies plenum 7 so closely that it could interfere with the clockwise rotation of the plenum 7 about axis 17. Therefore, the nozzle 4 must be moved to the home position, at which position it does not overlie the plenum 7, before such rotation is effected. To enable this movement, the nozzle 4 is mounted on a programmable stepper driven rail, i.e. a linear worm guide 21 which is driven by a stepper actuator 22 (see FIG. 3). The nozzle 4 and linear worm guide 21 are mounted on an under-screen printer baseplate 23, which is mounted to the printing machine via a linear drive (not shown) arranged for driving along the Y-axis.

FIG. 3 schematically shows a cleaning and dispensing system in accordance with this embodiment. Reference numerals are retained as far as possible. The dispensing system shown in FIG. 2 is here schematically shown from a top view, with components of the cleaning liquid supply shown in a simplified and functional form. The horizontal extent of the plenum 7 along the X-axis can be seen to be greater than the width of the roll of cleaning material 6. Linear worm guide 21 extends parallel to the X-axis, and extends beyond plenum 7 at each end thereof. With this arrangement, a home position for nozzle 4 may be provided at both ends of the linear worm screw, at which the nozzle may be parked during lifting of the plenum 7. Respective sensors 24, 25 are provided at each home position to detect when nozzle 4 is correctly positioned within that home position. Output from sensors 24, 25 is sent to a control system comprising control processor 11 (not shown in FIG. 3), to control the lifting of the plenum 7.

Stepper actuator 22 is controlled by the control processor 11 to drive the stepper actuator 22 to move the nozzle 4 along the linear worm guide 21 along a range of travel while cleaning liquid 2 is dispensed therefrom. This range of travel is programmable into the control processor 11, so that the length of the cleaning liquid bead 20 may be optimised for the particular aperture pattern on the stencil being cleaned. This programming may be performed by an operator, or automatically effected by a inspection system (not shown) capable of detecting the aperture pattern.

An exemplary method for using the above-described cleaning system may comprise the following steps occurring during the printing and cleaning operation:
A) The nozzle is moved to the home position if not already there, its presence at this home location being confirmed by a home sensor 24, 25;
B) Simultaneously:
   i) nozzle 4 sprays cleaning liquid 2 into the outlet tube 12, and outlet sensor 14 checks for the expected change in the presence of liquid. The outlet sensor 14 output is passed to control processor 11, and
   ii) plenum 7 is lifted up to the stencil and cleaning commences by drawing cleaning material 6 against the lower surface of the stencil;
C) Following cleaning, the plenum 7 is lowered;
D) The nozzle 4 is moved along a programmed range of travel to effect wetting of a predetermined width of cleaning material. Advantageously, this predetermined width corresponds to the width of the aperture pattern of the stencil.

During these stages, the priming sensor 9 monitors for an absence of cleaning liquid. If such an absence is detected, then a priming operation is performed, in which the pump 5 is operated to fill the feed tube 3 with cleaning liquid. If an absence is still detected following priming, then this indicates that operator attention is required and an alarm is raised. Possible causes may be that the storage tank 1 is empty, or that the pump 5 has failed.

If the outlet sensor 14 fails to detect a change in the presence of cleaning liquid in step Bii) above, this indicates either that there is a blockage in the liquid path between priming sensor 9 and outlet sensor 14 (for example due to the nozzle 4 being blocked), or that the liquid path is empty of liquid. These two alternatives may be distinguished by assessing the output of priming sensor 9 - an absence of cleaning liquid 2 indicates that the liquid path is empty of liquid, while if no output has been sent, then a blockage is implied.

The above-described embodiments are exemplary only, and other possibilities and alternatives within the scope of the invention will be apparent to those skilled in the art. For example, in other embodiments (not shown), a gravity-fed system may be employed, such that the storage tank 1 is positioned above the nozzle 3 in use. In this case the pump 4 may be omitted, however a valve or the like must instead be provided to control the flow of cleaning liquid from the storage tank 1, along the feed tube 2 to the nozzle 3.

It should be noted that a discontinuous range of travel is possible, such that two or more spatially separated beads of cleaning liquid may be applied to the cleaning material 6. In this case it would be necessary to interrupt the flow of cleaning liquid to the nozzle during its travel. This may be achieved by selective operation of the pump, or by providing a selectively operable valve in the feed tube for example.

### Reference Numerals:

1 - Storage tank
2 - Cleaning liquid
3 - Feed tube
4 - Nozzle
5 - Pump
6 - Cleaning material
7 - Plenum
8A, 8B - Clamps
9 - Priming sensor
10 - Priming sensor PCB
11 - Control processor
12 - Outlet tube
13 - Funnel
14 - Outlet sensor
15 - Presence sensor PCB
16 - Cleaning head
17 - Plenum rotation axis
18 - Clamp
19 - Cleaning material roll
20 - Cleaning liquid bead
21 - Linear worm guide
22 - Stepper actuator
23 - Under-screen printer baseplate
24, 25 - Home sensors
S - Stencil

## Claims

1. A cleaning system for cleaning a stencil within a printing machine, comprising:
a control processor,
a tank for storing cleaning liquid,
a cleaning liquid dispensing system comprising a nozzle for dispensing liquid onto a cleaning material,
a feed tube connected between the tank and the nozzle, and
a priming sensor for detecting cleaning liquid within a section of the feed tube, the priming sensor being operative to send a signal to the control system indicative of the detection of cleaning liquid.

2. The cleaning system of claim 1, wherein the priming sensor is operative to send a signal to the control system when it detects that no liquid is present within the section of the feed tube.

3. The cleaning system of either of claims 1 and 2, further comprising a pump connected between the tank and the feed tube section.

4. The cleaning system of any preceding claim, comprising an outlet tube for collecting cleaning liquid from the nozzle, and an outlet sensor operative to detect cleaning liquid within a region of the outlet tube; optionally the outlet sensor is operative to send a signal to the control system when the outlet sensor detects a change in the presence of liquid within the region of the outlet tube.

5. The cleaning system of claim 4, wherein the nozzle comprises a movable nozzle, which is movable between a home position in which the nozzle is aligned with the outlet tube to dispense cleaning liquid thereto and a dispensing position in which the nozzle is aligned with the cleaning material to dispense cleaning liquid thereto; optionally the cleaning system comprises an actuator for driving the movable nozzle.

6. The cleaning system of any preceding claim, wherein the or each priming sensor is an infra-red sensor.

7. A cleaning liquid dispensing system for dispensing cleaning liquid to a cleaning material within a printing machine, the cleaning material being an elongate sheet structure having a width, comprising:
a guide which spans the width of the cleaning material,
a movable nozzle in fluid connection with a source of cleaning liquid to receive a supply of cleaning liquid therefrom and to dispense the received cleaning liquid, the movable nozzle being movable along the guide to dispense cleaning liquid to a portion of the cleaning material proximate the movable nozzle in use,
an actuator for driving the movable nozzle along the guide,
a control system comprising a control processor for controlling the actuator, the control processor being operative to drive the actuator to move the movable nozzle along the guide along a range of travel while cleaning liquid is dispensed therefrom,
wherein the range of travel is programmable into the control processor.

8. The cleaning liquid dispensing system of claim 7, wherein in use the range of travel is controlled by the control processor to apply cleaning liquid to a predetermined portion of the cleaning material, the portion being a subset of the width of the cleaning material.

9. The cleaning liquid dispensing system of either of claims 7 and 8, comprising an outlet tube located at an end of the guide for receiving cleaning liquid dispensed from the movable nozzle.

10. The cleaning liquid dispensing system of any of claims 7 to 9, wherein the guide comprises a linear worm screw, which is rotatably driven by the actuator in use.

11. The cleaning liquid dispensing system of any of claims 7 to 10, comprising a home sensor located at an end of the guide, for detecting when the movable nozzle is located at said end.

12. The cleaning system of any of claims 1 to 6, wherein the cleaning liquid dispensing system comprises the system of any of claims 7 to 11.

13. A printing machine comprising the cleaning system of any of claims 1 to 6 or 12.

14. A printing machine comprising the cleaning liquid dispensing system of any of claims 7 to 11.

15. A method of cleaning a stencil within a printing machine, comprising the steps of:
i) providing a cleaning system comprising a control processor, a tank for storing cleaning liquid, a cleaning liquid dispensing system comprising a nozzle, and a feed tube connected between the tank and the nozzle; and
ii) detecting cleaning liquid within the feed tube.
